# FASCICULE DE BREVET EUROPEEN

(11) **EP 0 420 106 B1**
(45) Date de publication et mention de la délivrance du brevet: **07.12.1994**
(21) Numéro de dépôt: 90118313.7
(22) Date de dépôt: 24.09.1990
(51) Int. Cl.: H03H 11/24, H03G 1/00

(54) **Atténuateur à transistor à effet de champ bigrille**
Attenuatorschaltung mit einem Dual-Gate-Feldeffekttransistor
Attenuator using a dual gate field effect transistor

(30) Priorité: 26.09.1989 FR 8912587
(43) Date de publication de la demande: 03.04.1991
(73) Titulaire: ALCATEL ESPACE, F-92407 Courbevoie Cédex (FR); ALCATEL N.V., NL-1077 XX Amsterdam (NL)
(72) Inventeur: Roques, Daniel, F-31300 Toulouse (FR); Pouysegur, Michel, F-31400 Toulouse (FR); Cazaux, Jean-Louis, F-31100 Toulouse (FR)
(74) Mandataire: Weinmiller, Jürgen

(56) Documents cités:
- EP-A- 0 272 106
- US-A- 4 700 153
- GaAs IC SYMPOSIUM, TECHNICAL DIGEST 1987, Portland, Oregon, 13-16 octobre 1987, pages 235-238, IEEE, New York, US; R.J. NASTER et al.: "An L-band variable-gain amplifier GaAs MMIC with precise binary step control"
- 1988 IEEE MTT INTERNATIONAL MICROWAVE SYMPOSIUM DIGEST, New York, 25-27 mai 1988, vol. 1, pages 171-174, IEEE, New York, US; R.B. CULBERTSON et al.: "A 3-watt X-band monolithic variable gain amplifier"

## Description

L'invention se rapporte à un atténuateur à transistor à effet de champ bigrille.

Plusieurs techniques existent pour réaliser des atténuateurs, notamment en technologie MMIC (Monolithic Microwave Integrated Circuits) sur GaAs. Les deux principales sont celles qui utilisent des transistors à effet de champ ou "TEC" simple grille polarisés à tension drain source nulle (Vds = 0) ou bien des transistors à effet de champ (TEC) double grille.

Les atténuateurs à diode PIN réalisés en technologie hybride ne sont pas facilement transposables en technologie monolithique du fait de la difficulté de réaliser les diodes PIN sur un substrat de GaAs.

Les atténuateurs réalisés à base de TEC simple grille polarisés à Vds = 0, et que l'on trouve dans la littérature ne présentent pas des performances très pointues quant'à la variation de la phase d'insertion en fonction de la dynamique d'atténuation.

Par contre des essais ont déjà été effectués dans le domaine des atténuateurs à TEC bigrille pour essayer d'atteindre l'objectif recherché. Les travaux les plus récents portent sur des atténuateurs à TEC bigrille segmentés ; ainsi les deux articles suivants :
- "A Microwave Phase and Gain Controller with Segmented Dual-gate MESFET's in GaAs MMIC" de Y.C. HWANG, D. TEMME, Y.K. CHEN and R.J. NASTER (IEEE - Microwave and mm-wave Monolithic Circuits Symposium - mai 1984 pages 1-5) décrit un nouveau circuit constitué de plusieurs TEC bigrille qui permet un contrôle de gain précis sur une large bande hyperfréquence grâce à un choix adéquat du rapport des largeurs de grille : ce circuit contrôleur de gain hyperfréquence de précision ayant des applications potentielles comme atténuateur hyperfréquence de bande ultra-large ou comme déphaseur hyperfréquence actif.
- "Segmented Dual-Gate MESFET's for Variable Gain and Power Amplifiers in GaAs MMIC" de K.H. SNOW, J.J. KOMIAK, and D.A. BATES (IEEE - trans. on MTT, Vol. MTT-36, N° 12, Déc. 1988 - pages 1976-1985) décrit des circuits amplificateurs MMIC GaAs à puissance variable et gain variable utilisant un circuit TEC double grille.

Dans ces articles il s'agit d'atténuateurs numériques constitues de plusieurs TEC bigrille, chacun d'entre eux représentant un bit. la phase d'insertion varie entre 6° et 10° sur une dynamique de 20 dB selon la bande de fréquence. Le principe utilisé consiste à minimiser la variation de la phase d'insertion en optimisant individuellement la charge appliquée sur la 2ème grille des TEC bigrille constituant chacun des bits. Les charges utilisées sont des simples capacités dont la valeur varie d'un bit à l'autre. Cependant les pertes par réflexion en entrée et en sortie ne sont pas meilleures que 6 dB du fait de la difficulté d'adapter la série des TEC bigrille dans l'ensemble des états logiques possibles.

L'objet essentiel de l'invention est de réaliser un tel atténuateur en minimisant la variation de la phase d'insertion en fonction de l'atténuation.

L'invention propose à cet effet un atténuateur à transistor à effet de champ bigrille, dont la caractéristique essentielle est qu'une charge active variable est appliquée sur la seconde grille de ce transistor à effet de champ bigrille.

Avantageusement cette charge est constituée d'un transistor à effet de champ simple grille polarisé par tension drain-source nulle.

Par rapport aux dispositifs de l'art connu un tel atténuateur présente les avantages suivants :
- Variation de phase d'insertion inférieure sur une dynamique de 20 dB ;
- Pertes en retour bien meilleures sur l'ensemble de la dynamique (19 dB au lieu de 6 à 12 dB) ;
- Consommation inférieure (1 TEC bigrille au lieu de 6) ;
- Circuit plus simple et donc rendement de fabrication supérieur ;
- gamme continue de valeurs d'atténuation au lieu d'une série de valeurs discrètes.

Les caractéristiques et avantages de l'invention ressortiront d'ailleurs de la description qui va suivre, à titre d'exemple non limitatif, en référence aux figures annexées sur lesquelles :

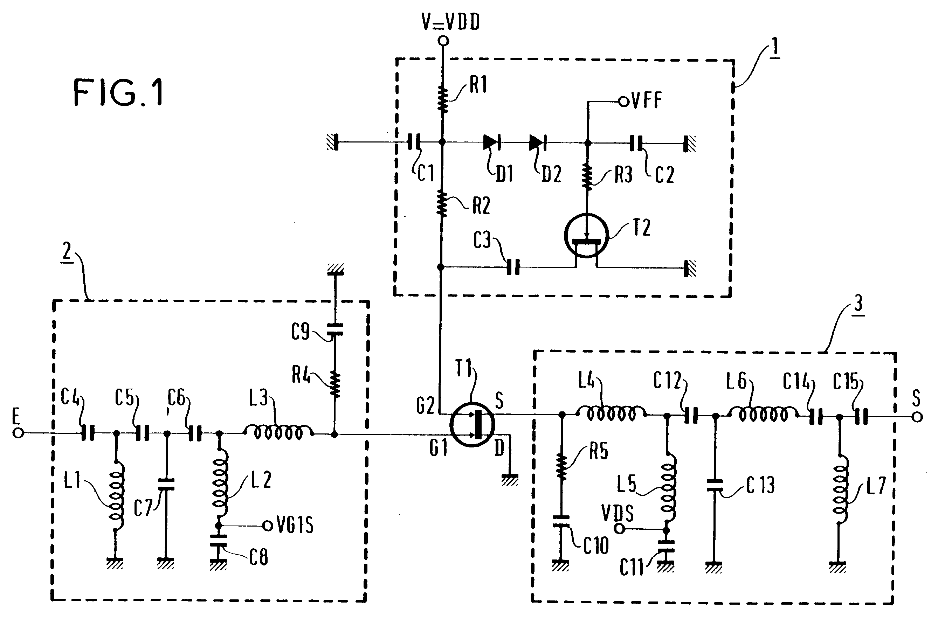

- la figure 1 illustre schématiquement l'atténuateur selon l'invention.
- les figures 2 et 3 sont deux courbes caractéristiques de cet atténuateur.

L'atténuateur de l'invention a pour objectif la minimisation de la variation de la phase d'insertion en fonction de l'atténuation. Son principe est applicable aussi bien dans la technologie hybride que monolithique sur GaAs, cependant sa mise en oeuvre semble bien plus aisée (et donne de meilleurs résultats) dans la technologie MMIC (Monolithic Microwave Integrated Circuits) sur GaAs. On considèrera donc cette technologie à titre d'exemple préférentiel.

Le dispositif atténuateur faisant l'objet de l'invention n'utilise qu'un seul transistor TEC bigrille T1, sur la deuxième grille duquel une charge optimale a été appliquée, réalisant à la fois les objectifs de platitude et de dynamique d'atténuation ainsi que celui de minimisation de la variation de phase d'insertion en fonction de l'atténuation.

Des charges passives relativement simples, voire très simples, comme une capacité, remplissent très bien les objectifs de platitude et de dynamique souhaités sur des largeurs de bande approchant l'octave. Cependant de telles charges passives ne permettent pas de maintenir la phase d'insertion constante sur une grande dynamique d'atténuation. Cette variation de phase peut atteindre 20 ou 30° sur des dynamiques d'atténuation de l'ordre de 20 dB. Ces performances ne sont pas satisfaisantes pour les applications de réseau de formation de pinceaux pour antenne active où les variations maximales souhaitables sont de 4 à 5° sur une dynamique de 20 dB.

Le principe de l'invention consiste à utiliser une charge active variable en remplacement de la charge passive. En effet, si l'on déplace sur l'abaque de Smith le point représentatif de la charge appliquée sur la 2ème grille, on n'observe pas de variation sensible de la phase d'insertion tant que l'on reste dans une moitié d'abaque voisine du court-circuit. Cependant lorsqu'on se rapproche du circuit ouvert, la phase absolue des forts états d'atténuation subit des variations très importantes au point de se rapprocher de celle des faibles états d'atténuation pour lesquels au contraire on s'est placé relativement loin du circuit ouvert.

L'invention consiste donc à utiliser une charge variable 1 présentant les caractéristiques suivantes :
- Impédance de valeur finie mais croissante sur une grande partie de la dynamique d'atténuation (cette dernière n'est pas très sensible à la valeur de la charge dans la mesure où celle-ci se situe loin du court-circuit) ;
- Impédance de valeur très grande (près du circuit ouvert) pour les fortes valeurs d'atténuation.

Un transistor TEC T2 polarisé à Vds = 0 (TEC "froid") répond aux conditions énoncées ci-dessus. En effet, il se comporte comme une résistance variable (aux capacités Cgs, Cgd, Cds près) dont la valeur croit de quelques Ω à Vgs = 0 jusqu'à plusieurs kΩ près du pincement, où seules les capacités parasites de faible valeur limitent l'accès au court-circuit idéal.

Ainsi il est possible de balayer la dynamique d'atténuation en faisant varier simultanément la tension VG2S (appliquée sur la seconde grille G2 du TEC bigrille) et la charge appliquée sur cette même seconde grille G2. Le transistor T2, ou TEC "froid", constitue cette charge dont la valeur est fonction de la tension Vgso appliquée sur sa grille.

Il en résulte une variation quasi-nulle de la phase d'insertion sur une grande dynamique d'atténuation.

Un atténuateur commandable en technologie MMIC sur GaAs fonctionnant dans la bande 3-5 GHz a été développé à l'aide de modèles de TEC, bigrille T1 et de TEC "froid" T2 proposés par un fabricant de circuits GaAS. La largeur de grille du TEC "froid" T2 a été optimisée pour réaliser le déphasage minimum sur la plus grande dynamique d'atténuation possible.

Une capacité C3 située entre la seconde grille G2 et le drain du TEC "froid" T2 permet la séparation de leurs polarisations.

Cette capacité n'a quasiment pas d'effets sur les performances obtenues.

La seconde grille (G2) du bigrille T1 et celle du TEC "froid" T2 sont polarisées à travers des résistances de fortes valeurs R2 et R3 de manière à séparer les signaux hyperfréquences de la polarisation.

Cependant lorsque la tension de polarisation (VG2S) appliquée sur la seconde grille du FET bigrille T1 varie de +1 à -0.5 V, celle appliquée (VGSO) sur la grille du FET "froid" T2 doit varier de -0.5 V à -2 V. Il faut donc maintenir constamment une différence de 1.5 V entre ces deux tensions. Une commande unique permet de générer simultanément les deux tensions VG2S et VGSO. Ceci est réalisé à l'aide de deux TEC utilisés en diodes D1 et D2 et polarisés au coude de leur caractéristique courant-tension (VGS = +0.75 V). Leur mise en série donne à leurs bornes une tension de 1.5 Volts.

Les circuits 2 et 3 sont des réseaux d'adaptation entrée et sortie réalisés en éléments localisés (inductances et capacités). Le réseau d'adaptation en gain d'entrée permet l'adaptation de la ligne d'entrée E à l'impédance d'entrée du transistor FET bigrille T1.

Le réseau d'adaptation en gain de sortie permet l'adaptation de l'impédance de sortie du transistor FET bigrille T1 à la ligne de sortie S.

De tels circuits transformateurs d'impédance sont connus de l'homme de l'art.

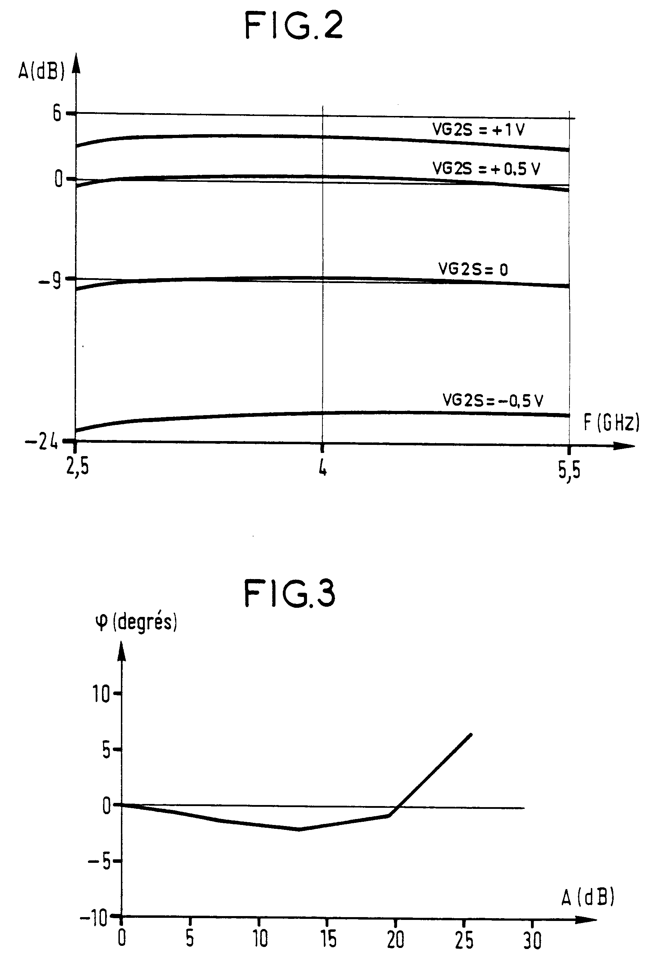

Les courbes, représentées à la figure 2, sont des courbes de l'atténuation A (dB) en fonction de la fréquence F (GHz) donnée pour différentes valeurs de VG2S : soient + 1 Volt ; + 0,5 Volt ; 0 Volt ; - 0,5 Volt.

La courbe représentée à la figure 3 est une courbe de la phase φ (degrés) en fonction de l'atténuation A (dB) pour une fréquence F = 4 GHz.

La courbe représentée à la figure 3 est obtenue, par exemple, avec des éléments ayant les valeurs suivantes :
- circuit charge variable
   C1 = 10 pF
   C2 = 10 pF
   C3 = 1 pF
   R1 = 2,25 kΩ
   R2 = R3 = 10 kΩ
- Réseau d'adaptation d'entrée
   C4 = 2 pF
   C5 = 1,5 pF
   C6 = 1,6 pF
   C7 = 0,4 pF
   C8 = 10 pF
   C9 = 0,6 pF
   R4 = 215 Ω
   L1 = 2 nH
   L2 = 2,8 nH
   L3 = 4 nH
- Réseau d'adaptation de sortie
   C10 = 0,5 pF
   C11 = 10 pF
   C12 = 0,8 pF
   C13 = 0,2 pF
   C14 = 2,6 pF
   C15 = 2,2 pF
   R5 = 215 Ω
   L4 = 3,2 nH
   L5 = 4,2 nH
   L6 = 1 nH
   L7 = 2,4 nH
- Transistor FET bigrille
   L = 0,5 µm
   W = 150 µm
- Transistor FET monogrille (TEC "froid")
   L = 0,5 µm
   w = 37,5 µm

L'invention s'applique notamment au domaine des antennes actives, comportant un réseau de sources associé à un réseau de formation de pinceau (BFN) à commande électronique, dans lesquelles le pointage du faisceau est lié à la phase, l'atténuation devant donc être indépendante de la phase et de la fréquence.

Ce type d'atténuateur est ainsi utilisé par centaines d'unités dans les réseaux de formation de pinceaux d'antennes actives. Ils doivent réaliser la loi d'amplitude désirée sans perturber la loi de phase, générée indépendamment par un réseau de déphaseurs. Ainsi la variation de la phase d'insertion de ces atténuateurs doit rester très faible sur toute la dynamique d'atténuation.

Les performances obtenues sont les suivantes :
- Bande passante : 2.75 GHz - 5.25 GHz ;
- Pertes en retour aux accès : meilleures que 19 dB quelque soit l'atténuation ;
- Dynamique d'atténuation 25 dB ;
- Variation de la phase d'insertion : ≦ 2° sur 20 dB de dynamique ;
- Platitude de l'atténuation sur la bande quelque soit l'atténuation : ± 0.3 dB.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

Ainsi l'invention peut s'appliquer également, pour un amplificateur de canal à commande de gain.

## Revendications

1. Atténuateur à transistor à effet de champ bigrille (T1), caractérisé en ce qu'une charge active variable (1) est appliquée sur la seconde grille de ce transistor (T1) à effet de champ bigrille.

2. Atténuateur selon la revendication 1, caractérisé par le fait que la charge active variable comporte un transistor effet de champ simple grille (T2) polarisé par une tension drain-source nulle.

3. Atténuateur selon l'une quelconque des revendications 1 ou 2, caractérisé par le fait qu'il a une bande passante comprise entre 2,75 et 5,25 GHz.

## Patentansprüche

1. Dämpfungsglied auf der Basis eines Feldeffekttransistors mit doppeltem Gate (T1), dadurch gekennzeichnet, daß eine veränderliche aktive Last (1) an das zweite Gate des Feldeffekttransistors mit Doppelgate (T1) angelegt ist.

2. Dämpfungsglied nach Anspruch 1, dadurch gekennzeichnet, daß die veränderliche aktive Last einen Feldeffekttransistor mit Einzelgate (T2) aufweist, der durch eine Drain-Source-Spannung von OV vorgespannt ist.

3. Dämpfungsglied nach Anspruch 1 und 2, dadurch gekennzeichnet, daß er einen Durchlaßbereich zwischen 2,75 und 5,25 Gigahertz aufweist.

## Claims

1. A dual-gate field effect transistor attenuator characterized in that a variable active load (1) is applied to the second gate of the dual-gate field effect transistor (T1).

2. An attenuator according to claim 1, characterized by the fact that the variable active load comprises a single-gate field effect transistor (T2) biased to have zero drain-source voltage.

3. An attenuator according to claim 1 or 2, characterized by the fact that its passband covers the range 2.75 GHz to 5.25 GHz.
